Europäisches Patentamt

European Patent Office

Office européen des brevets

(19)

(11) Numéro de publication : **0 457 654 A1**

# (12) DEMANDE DE BREVET EUROPEEN

(21) Numéro de dépôt : **91401199.4**

(22) Date de dépôt : **07.05.91**

(51) Int. Cl.$^5$ : **H01L 39/24**

(30) Priorité : **18.05.90 FR 9006222**

(43) Date de publication de la demande :
**21.11.91 Bulletin 91/47**

(84) Etats contractants désignés :
**AT BE CH DE DK ES FR GB GR IT LI LU NL SE**

(71) Demandeur : **RHONE-POULENC CHIMIE**
**25, quai Paul Doumer**
**F-92408 Courbevoie Cédex (FR)**

(72) Inventeur : **Michel, Claude**
**1, Allée des Epis**
**F-14200 Herouville (FR)**
Inventeur : **Pham, Ai-Quoc**
**1, Place de la Hêtraie**
**F-94450 Limeil-Brevanne (FR)**
Inventeur : **Raveau, Bernard, Lotissement**
**"Les Vickings"**
**Allée Guillaume le Conquérant**
**F-14112 Bieville-Beuville (FR)**

(74) Mandataire : **Dubruc, Philippe et al**
**RHONE-POULENC CHIMIE Service Brevets**
**Chimie 25, quai Paul-Doumer**
**F-92408 Courbevoie Cédex (FR)**

(54) **Procédé de préparation d'une composition supraconductrice à base d'yttrium, ou d'une terre rare, d'un alcalino-terreux, de cuivre et d'oxygène.**

(57) L'invention concerne un procédé de préparation d'une composition supraconductrice du type $L_{1-x}$ $M'_x M_{2-y} M''_y Cu_4 O_8$, L étant l'yttrium, une terre rare ou une combinaison de ces éléments, M' étant un élément de valence inférieure à celle de l'élément L, M étant un alcalino-terreux, M'' étant un élément de valence inférieure ou égale à 2, $O \leq x \leq 0,3$ et $0 \leq y \leq 1$. Ce procédé est caractérisé en ce qu'on mélange des composés comprenant les éléments L, M', M, M'', Cu et O en quantités convenables avec un additif qui est un peroxyde ou un hyperoxyde alcalin, puis on chauffe et on fait réagir le mélange ainsi obtenu.

Le procédé de l'invention est mis en oeuvre à la pression normale d'oxygène et il s'applique particulièrement bien à la préparation des phases $YBa_2Cu_4O_8$ et $Y_{0,9}Ca_{0,1}Ba_2Cu_4O_8$ notamment.

EP 0 457 654 A1

La présente invention concerne la préparation d'une composition supraconductrice à base d'yttrium ou d'une terre rare, d'un alcalino-terreux, de cuivre et d'oxygène, du type YBaCuO notamment.

Plus précisément, elle concerne les compositions du type appelé habituellement "1 2 4" comme par exemple $YBa_2Cu_4O_8$.

Parmi les compositions supraconductrices étudiées ces dernières années, on connaît la phase $YBa_2Cu_3O_7$ (1 2 3) qui est la première d'une série de formule générale $Y_2Ba_4Cu_{6+n}O_{14+n}$ (n = O).

On connaît par ailleurs dans cette même série la phase $YBa_2Cu_4O_8$ (1 2 4) (n = 2) dont la Tc onset (en magnétisme) est de 81K et une phase dérivée de celle-ci par substitution au calcium $Y_{0,9}Ca_{0,1}Ba_2Cu_4O_8$ et dont la Tc onset est de 90K. Outre ces températures critiques assez élevées, ces dernières phases sont en plus particulièrement intéressantes à cause de la stabilité de leur teneur en oxygène à haute température, ce qui les rend tout à fait aptes à être utilisées dans la fabrication de pièces industrielles (fils composites par exemple), fabrication impliquant des températures élevées.

Mais il se trouve que la préparation des compositions supraconductrices du type 1 2 4 nécessite généralement de travailler à pression élevée par exemple comprise entre 3 et 40 MPa. De telles pressions entraînent l'utilisation d'appareillages complexes, ce qui complique beaucoup la mise au point d'un procédé industriel.

D'autres procédés ont été proposés pour s'affranchir des hautes pressions, mais ces procédés ne sont pas satisfaisants car ils conduisent à des phases qui ne sont pas pures et dont les températures critiques sont plus basses que les températures critiques des phases préparées sous haute pression.

L'objet principal de l'invention est donc la mise au point d'un procédé simple de préparation de compositions supraconductrices du type $YBa_2Cu_4O_8$ et dérivées à températures critiques et à pureté les plus grandes possibles.

Dans ce but et selon un mode de réalisation préféré de l'invention, le procédé de préparation d'une composition supraconductrice du type $L_{1-x}M'_xM_{2-y}M''_yCu_4O_8$, L étant l'yttrium, une terre rare ou une combinaison de ces éléments, M' étant un élément de valence inférieure à celle de l'élément L, M étant un alcalino-terreux, M'' étant un élément de valence inférieure ou égale à 2, $O \leqq x \leqq 0,3$ et $O \leqq y \leqq 1$, est caractérisé en ce qu'on mélange des composés comprenant les éléments L, M', M, M'', Cu et O avec un additif qui est un peroxyde ou un hyperoxyde alcalin, puis on chauffe et on fait réagir le mélange ainsi obtenu.

Selon un second mode de réalisation de l'invention, le procédé de préparation d'une composition supraconductrice du type $L_{1-x}M'_xM_{2-y}M''_yCu_4O_8$, L, M', M, M'' et x étant tels que définis ci-dessus, est caractérisé en ce que dans une première étape on mélange un composé comprenant du cuivre et de l'oxygène avec un peroxyde ou un hyperoxyde alcalin; on chauffe et on fait réagir le premier mélange ainsi formé, puis dans une deuxième étape, on mélange le produit de réaction obtenu précédemment avec des composés comprenant les éléments L, M', M, M'' et O, et éventuellement Cu, en quantités convenables, on chauffe et on fait réagir le second mélange ainsi obtenu.

Le procédé de l'invention permet d'opérer à la pression normale d'oxygène tout en donnant des produits purs et à température critique égale à ou très proches de celles des produits obtenus sous haute pression.

D'autres caractéristiques et avantages de l'invention apparaîtront plus clairement à la lecture de la description et des exemples concrets mais non limitatifs qui vont suivre.

L'invention s'applique aux compositions supraconductrices du type :

$$L_{1-x}M'xM_{2-y}M''_yCu_4O_8 \quad (1)$$

L est choisi parmi l'yttrium et les lanthanides ou terres rares, c'est-à-dire les éléments 57 à 71 de la classification périodique. L peut être plus particulièrement l'yttrium. On peut aussi citer l'erbium notamment. Il est entendu que L peut aussi désigner dans la formule (1) une combinaison d'éléments du type précité.

M est choisi dans le groupe des alcalino-terreux. L'invention s'applique particulièrement bien au cas où M est le baryum.

L'élément de substitution M' est un élément de valence inférieure à celle de l'élément L, ce peut être plus particulièrement un élément divalent. Il est choisi de préférence parmi les éléments divalents de taille voisine de celle de l'élément L. Il peut s'agir par exemple d'un élément des groupes Ia, IIa, IIb. On peut mentionner notamment le calcium, le sodium ou le cambium.

Dans le cas où M est le baryum, M' est différent de M.

M'' est un élément de valence inférieure ou égale à 2. On le choisit de préférence parmi les éléments de taille voisine de celle de M. Il peut s'agir en particulier d'un élément des groupes Ia, IIa, IIb. On peut mentionner comme exemple le potassium ou le strontium.

Lorsque x = y = O dans la formule (1), on a donc les compositions du type $LM_2Cu_4O_8$ dont un exemple pour lequel l'invention convient très bien est $YBa_2Cu_4O_8$.

L'invention s'applique aussi particulièrement bien aux compositions de ce type mais substituées, compositions de formule (1) dans laquelle x > O et y = O.

La valeur de x varie entre 0 et 0,3 inclus, de préférence entre 0 et 0,1. On peut mentionner particulièrement les compositions pour lesquelles $x = 0,1$ et $y = O$ du type $L_{0,9}M'_{0,1}M_2Cu_4O_8$, M' étant notamment le calcium.

Le procédé de l'invention peut être mis en oeuvre selon deux modes de réalisation.

Le mode préféré va tout d'abord être décrit.

Selon ce mode, le procédé consiste tout d'abord à mélanger des composés comprenant les éléments L, M, Cu, O et éventuellement M' et M''.

Généralement, les composés comprenant les éléments précités sont choisis parmi les oxydes ou péroxydes de ces éléments ou leurs sels d'acides inorganiques ou organiques.

D'une manière générale, en ce qui concerne les sels, ceux-ci doivent être choisis parmi ceux susceptibles de se décomposer facilement lors des étapes de chauffage ultérieurs du procédé.

Pour les sels d'acides inorganiques, on peut citer les chlorures, les carbonates et de préférence les nitrates.

Pour les sels d'acides organiques, on peut utiliser les sels des acides organiques aliphatiques, notamment des acides aliphatiques saturés par exemple l'acide acétique.

On peut aussi mentionner les sels des diacides, notamment des diacides aliphatiques comme par exemple l'acide oxalique ainsi que les sels des polyacides-alcools tels que par exemple les acides citrique, malique, tartrique, glycolique, lactique. Les sels des acides organiques complexants conviennent bien généralement.

A titre d'exemple, on utilise pour l'élément L les oxydes $L_2O_3$ comme $Y_2O_3$.

Pour le cuivre, on utilise notamment CuO. Le baryum peut être employé par exemple sous forme de nitrate, d'oxyde ou de péroxyde.

Certains des éléments précités peuvent être utilisés sous forme combinée et notamment d'oxyde combiné, tel que par exemple $MCuO_2$ et tout particulièrement $BaCuO_2$, $L_2MCuO_5$ et notamment $Y_2BaCuO_5$ et $LM_2Cu_3O_7$, comme $YBa_2Cu_3O_7$.

Selon une caractéristique essentielle de l'invention, on utilise en outre un additif qui est un peroxyde ou un hyperoxyde alcalin. A titre de métal alcalin, on peut mentionner tout particulièrement le sodium et le potassium.

Ainsi, on peut choisir l'additif parmi le groupe comprenant le peroxyde de sodium $Na_2O_2$, le peroxyde de potassium $K_2O_2$, l'hyperoxyde de potassium $KO_2$. On peut aussi utiliser ces réactifs en combinaison.

On effectue un mélange intime de l'additif et des composés dans les quantités convenables, c'est-à-dire correspondant aux proportions stoechiométriques la composition finale recherchée.

La quantité d'additif utilisée n'est pas critique. Toutefois, il est préférable d'utiliser une quantité minimale qui correspond au quart de la quantité de cuivre en mole dans la composition supraconductrice. Une quantité plus grande permet d'améliorer la pureté de la phase finale. Il est aussi préférable de ne pas dépasser une quantité allant jusqu'à 3/4 de la quantité de cuivre en mole car au-delà il n'y a plus d'amélioration de cette pureté.

On chauffe ensuite le mélange obtenu de manière à provoquer une réaction à l'état solide et à former ainsi la composition recherchée.

Le chauffage et la réaction se font sous atmosphère d'oxygène, de préférence en maintenant un balayage d'oxygène. On travaille en principe à la pression normale.

La température minimale à laquelle se font le chauffage et la réaction est fixée par la cinétique de la réaction.

La température maximale est fixée par la stabilité en température de la phase.

En pratique, le chauffage et la réaction se font à une température d'au moins 700°C, notamment d'au moins 800°C et plus particulièrement entre 800 et 840°C.

La durée du chauffage et de la réaction est habituellement comprise entre environ 60 et environ 120 heures.

A l'issue du chauffage, on laisse refroidir le produit obtenu. On le lave à l'eau éventuellement pour éliminer les traces d'oxydes alcalins.

Selon une première variante particulière du mode de réalisation qui vient d'être décrit, on conduit le chauffage et la réaction en deux temps.

Dans un premier temps, on chauffe le mélange de départ à une température d'au moins 300°C. Plus précisément, cette température peut être comprise entre 300 et 450°C. Le choix de cette température dépend de la nature de l'additif utilisé. Avec le peroxyde ou l'hyperoxyde de potassium, on peut se placer dans la partie basse de la fourchette donnée ci-dessus par exemple entre 300 et 350°C. Avec le péroxyde de sodium, il est préférable de travailler dans la partie haute de cette même fourchette par exemple entre 400 et 450°C.

Généralement, on maintient le milieu réactionnel à la température donnée ci-dessus pendant un temps compris entre 30 et 70 heures, par exemple d'environ 50 heures.

Il est à noter que lors de ce premier chauffage, on peut monter en température assez rapidement c'est-à-dire à des vitesses de l'ordre de 200°C/h par exemple.

Dans un deuxième temps, on monte le milieu réactionnel à une température d'au moins 700°C. Plus particulièrement cette température peut être d'au moins 800°C. La température maximale est fixée par la stabilité en température de la phase. Généralement, il est préférable de ne pas dépasser 840°C.

En pratique, on maintient un palier à la température ci-dessus pendant une durée d'au moins 50 heures et en particulier comprise entre 60 et 80 heures environ.

La montée en température, dans ce deuxième temps, peut être plus lente que celle du premier temps, de préférence elle ne doit pas dépasser 300°C/h.

Une seconde variante de ce même mode consiste à ne pas observer de palier entre 300 et 700°C, mais à monter progressivement en température sous une vitesse d'au plus 50°C/h. Ensuite, une fois à 700°C, on procède dans les mêmes conditions que celles décrites dans la première variante mentionnée ci-dessus.

Par ailleurs, dans le cadre de ce premier mode de réalisation, il est possible de rajouter de l'additif lors de l'étape de chauffage-réaction.

Le second mode de réalisation du procédé qui va maintenant être décrit consiste dans une première étape à mélanger un composé comprenant du cuivre et de l'oxygène avec un peroxyde ou un hyperoxyde alcalin.

Ce qui a été dit plus haut sur la nature du peroxyde ou de l'hyperoxyde s'applique de même ici.

Généralement le composé comprenant du cuivre et de l'oxygène est l'oxyde CuO.

On notera ici qu'il n'est pas nécessaire dans cette première étape d'utiliser le composé comprenant le cuivre dans la quantité correspondant à la quantité totale de cuivre de la composition supraconductrice finale. Cette quantité peut être par exemple de l'ordre du quart de la quantité totale.

Le mélange ainsi constitué est chauffé de manière à réagir. Les conditions de température sont celles qui ont été données plus haut pour le premier temps du mode de réalisation particulier de la variante précédente.

La réaction est là aussi conduite sous atmosphère d'oxygène à la pression normale ou à son voisinage.

La durée de cette première étape peut varier entre une et deux semaines, la durée la plus faible étant observée pour la réaction avec le réactif à base de potassium.

Les produits formés étant hygroscopiques, la réaction doit être conduite dans une atmosphère sans humidité.

La deuxième étape consiste à mélanger le produit issu de l'étape précédente avec les composés comprenant les autres éléments de la composition (L, M', M et M" notamment) et éventuellement le cuivre s'il n'a pas été introduit en totalité dans la première étape.

Les conditions de température et de durée pour cette seconde étape sont les mêmes que celles données au sujet du second temps de la variante particulière du mode de réalisation précédent.

Comme dans le mode de réalisation précédent, on refroidit et on lave éventuellement le produit obtenu.

D'une manière générale, le procédé de l'invention permet d'obtenir des produits présentant une pureté déterminée aux rayons X d'au moins 95%.

Des exemples concrets vont maintenant être donnés.

## EXEMPLE 1

Cet exemple concerne la synthèse de $YBa_2Cu_4O_8$.

0,64 g de CuO, 0,227 g de $Y_2O_3$, 1,051 g de $Ba(NO_3)_2$ anhydre ainsi que 0,160 g de $Na_2O_2$ ont été mélangés intimement dans un mortier. Ce mélange resté sous forme de poudre a été transféré dans un creuset en alumine, puis chauffé sous 1 bar d'oxygène, avec une rampe de 200°C/h jusqu'à 400°C. La température a été ensuite maintenue à cette valeur pendant 48 heures. Après cette étape, on a augmenté la température à une vitesse de 50°C/h jusqu'à 810°C. Une fois à 810°C, l'échantillon a été maintenu à cette température pendant 60 heures, toujours sous 1 bar d'oxygène. Le refroidissement de l'échantillon a été effectué à la vitesse de 200°C/h.

Le produit a été ensuite broyé, lavé abondamment à l'eau pour enlever l'oxyde de sodium restant (un contrôle par papier pH a montré que la solution était basique). Le séchage a été fait à l'étuve à 100°C.

Le produit final était une poudre noire. L'analyse aux rayons X a montré une pureté phasique de 95%.

41, 3 mg de cette poudre ont été testés à l'aide d'un magnétomètre à SQUID dans un champ de 10 gauss. On a mesuré une température de début de transition de 82K.

## EXEMPLE 2

Cet exemple concerne la synthèse de $Y_{0,9}Ca_{0,1}Ba_2Cu_4O_8$.

On procède de la même manière que dans l'exemple 1, mais avec les produits de départ ci-dessous dans les quantités indiquées.

$Na_2O_2$ : 0,370 g          CaO        : 0,018 g

CuO   : 1,006 g          $Ba(NO_3)_2$ : 1,654 g

$Y_2O_3$  : 0,322 g

L'analyse aux rayons X montre une pureté phasique de 95% 10 mg de la poudre obtenue ont été testés à l'aide d'un magnétomètre à SQUID sous un champ de 10 gauss. On a mesuré une température de début de transition de 91K.

## Revendications

**1** - Procédé de préparation d'une composition supraconductrice du type $L_{1-x}$ $M'_xM_{2-y}M''_yCu_4O_8$, L étant l'yttrium, une terre rare ou une combinaison de ces éléments, M' étant un élément de valence inférieure à celle de l'élément L, M étant un alcalino-terreux, M" étant un élément de valence inférieure ou égale à 2, $O \leqq x \leqq 0,3$ et $0 \leqq y \leqq 1$, caractérisé en ce qu'on mélange des composés comprenant les éléments L, M', M, M", Cu et 0 avec un additif qui est un peroxyde ou un hyperoxyde alcalin, puis on chauffe et on fait réagir le mélange ainsi obtenu.

**2** - Procédé de préparation d'une composition supraconductrice du type $L_{1-x}$ $M'_xM_{2-y}M''_yCu_4O_8$, L étant l'yttrium, une terre rare ou une combinaison de ces éléments, M' étant un élément de valence inférieure à celle de l'élément L, M étant un alcalino-terreux, M" étant un élément de valence inférieure ou égale à 2, $O \leqq x \leqq 0,3$ et $O \leqq y \leqq 1$, caractérisé en ce que dans une première étape on mélange un composé comprenant du cuivre et de l'oxygène avec du peroxyde ou un hyperoxyde alcalin, on chauffe et on fait réagir le premier mélange ainsi formé; puis dans une deuxième étape, on mélange le produit de réaction obtenu précédemment avec des composés comprenant les éléments L, M', M, M" et O, et éventuellement Cu, en quantités convenables, on chauffe et on fait réagir le second mélange ainsi obtenu.

**3** - Procédé selon la revendication 1 ou 2, caractérisé en ce que l'alcalin du peroxyde ou de l'hyperoxyde est le sodium ou le potassium.

**4** - Procédé selon l'une des revendications précédentes, caractérisé en ce qu'on prépare une composition supraconductrice dans laquelle M' est un élément divalent, en particulier choisi parmi les groupes Ia, IIa, IIb de la classification périodique, M' étant différent de M si M est le baryum.

**5** - Procédé selon l'une des revendications précédentes, caractérisé en ce qu'on prépare une composition supraconductrice dans laquelle M" est un élément de taille voisine de celle de M, en particulier choisi parmi les groupes Ia, IIa, IIb de la classification périodique.

**6** - Procédé selon l'une des revendications précédentes, caractérisé en ce qu'on prépare une composition supraconductrice dans laquelle M est le baryum.

**7** - Procédé selon l'une des revendications précédentes, caractérisé en ce qu'on prépare une composition supraconductrice dans laquelle L est l'yttrium.

**8** - Procédé selon l'une des revendications précédentes, caractérisé en ce qu'on prépare une composition supraconductrice dans laquelle M' est le calcium.

**9** - Procédé selon l'une des revendications précédentes, caractérisé en ce qu'on prépare une composition supraconductrice dans laquelle $O \leqq x \leqq 0,1$.

**10** - Procédé selon l'une des revendications précédentes, caractérisé en ce qu'on chauffe et fait réagir le ou les mélanges précités sous oxygène.

**11** - Procédé selon l'une quelconque des revendications 1 et 3 à 10, caractérisé en ce qu'on chauffe le mélange à une température d'au moins 300°C dans un premier temps, puis à une température d'au moins 700°C dans un second temps.

**12** - Procédé selon la revendication 11, caractérisé en ce qu'on chauffe dans un premier temps à une température comprise entre 300 et 450°C.

**13** - Procédé selon l'une des revendications 2 à 10, caractérisé en ce que dans la première étape précitée, on chauffe et fait réagir le premier mélange à une température d'au moins 300°C et en ce que dans la seconde étape précitée, on chauffe et on fait réagir le second mélange à une température d'au moins 700°C.

**14** - Procédé selon l'une des revendications précédentes, caractérisé en ce qu'on choisit les composés comprenant les éléments L, M', M, M", Cu et O parmi les oxydes, peroxydes ou oxydes combinés des éléments L, M', M, M" et Cu, ou les sels d'acides inorganiques ou organiques de ces éléments.

**15** - Procédé selon l'une des revendications précédentes, caractérisé en ce qu'on utilise une quantité de peroxyde ou d'hyperoxyde alcalin égale à au moins 1/4 de la quantité de cuivre en mole.

**16** - Procédé selon l'une des revendications 1, 3 à 12 et 14 ou 15, caractérisé en ce qu'on chauffe progressivement le mélange jusqu'à une température de 700°C au moins, puis on le maintient à cette température.

Office européen
des brevets

**RAPPORT DE RECHERCHE EUROPEENNE**

Numero de la demande

EP 91 40 1199

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | APPLIED PHYSICS LETTERS vol. 52, no. 24, 13 juin 1988, pages 2077-2079, New York, NY, US; A. GUPTA et al.: "Superconducting oxide films with high transition temperature prepared from metal trifluoroacetate precursors" * page 2077, colonne 2; abrégé * | 1,2,6,7,9,10,14 | H 01 L 39/24 |
| A | idem | 3,4,15 | |
| X | WO-A-8 907 086 (DU PONT DE NEMOURS) * pages 11,12 * | 1,3,16 | |
| A | | 2,8,11-13,15 | |

DOMAINES TECHNIQUES RECHERCHES (Int. Cl.5)

H 01 L

Le présent rapport a été établi pour toutes les revendications

| Lieu de la recherche | Date d'achèvement de la recherche | Examinateur |
|---|---|---|
| BERLIN | 14-06-1991 | JUHL A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)